# FASCICULE DE BREVET EUROPEEN

(11) **EP 4 239 881 B1**
(45) Date de publication et mention de la délivrance du brevet: **22.07.2026**
(21) Numéro de dépôt: 23157441.9
(22) Date de dépôt: 20.02.2023
(51) Int. Cl.: H03F 1/34, H03F 3/45, H03F 1/08

(54) **PROCÉDÉ DE COMPENSATION D'UN DÉCALAGE INTERNE EN TENSION ENTRE DEUX ENTRÉES D'UN AMPLIFICATEUR**
VERFAHREN ZUM KOMPENSIEREN EINES INTERNEN SPANNUNGSOFFSETS ZWISCHEN ZWEI EINGÄNGEN EINES VERSTÄRKERS
METHOD FOR COMPENSATING AN INTERNAL VOLTAGE OFFSET BETWEEN TWO INPUTS OF AN AMPLIFIER

(30) Priorité: 03.03.2022 FR 2201863
(43) Date de publication de la demande: 06.09.2023
(73) Titulaire: STMicroelectronics (ALPS) SAS, 38000 Grenoble (FR)
(72) Inventeur: LENZ, Kuno, 38340 Voreppe (FR)
(74) Mandataire: Casalonga

(56) Documents cités:
- US-A1- 2010 213 983
- US-B1- 11 239 807

## Description

Des modes de réalisation et de mise en œuvre concernent la calibration d'un circuit d'amplificateur opérationnel.

Un amplificateur opérationnel permet de réaliser une opération entre différents signaux d'un circuit intégré, en particulier une amplification de gain très élevée (typiquement de l'ordre de 100 à 1000). Lors de la calibration, la contre-réaction de l'amplificateur est typiquement désactivée et l'amplificateur en boucle ouverte a un fonctionnement de comparateur.

Un niveau de tension est généré en sortie de l'amplificateur lorsque des tensions sont appliquées sur l'entrée inverseuse et non-inverseuse de l'amplificateur. En particulier, le niveau de tension varie selon le signe de l'écart entre les tensions d'entrées lorsque l'amplificateur est utilisé comme un comparateur. Autrement dit, un premier niveau de tension est généré pour un écart positif et un deuxième niveau de tension est généré pour un écart négatif. L'écart est positif lorsque la tension appliquée sur l'entrée non-inverseuse est supérieure à la tension appliquée sur l'entrée inverseuse de l'amplificateur et est négatif dans le cas contraire.

Pour produire un niveau de tension à partir des tensions d'entrée, l'amplificateur comprend généralement plusieurs étages en interne formés par des circuits analogiques, en particulier un étage différentiel d'entrée.

L'étage différentiel prévoit typiquement des éléments internes répartis sur deux branches pour chaque entrée de l'amplificateur et transmet l'écart en tension entre les entrées aux autres étages de l'amplificateur.

Les éléments internes sont des composants analogiques tels que des transistors par exemple qui sont commandés par les tensions appliquées sur chaque entrée de l'amplificateur. Ces éléments sont typiquement choisis pour avoir des caractéristiques identiques entre les deux branches de sorte que la tension produite par l'étage différentiel soit représentative de l'écart réel en tension entre les entrées de l'amplificateur.

Néanmoins, les caractéristiques des éléments internes peuvent être différentes en raison d'aléas physiques des procédés de fabrications et/ou diverger au cours du temps. Une différence entre ces caractéristiques entraîne un décalage interne en tension entre les entrées de l'amplificateur. Ce décalage en tension, usuellement nommé « tension de décalage » (et connu sous le terme « offset » en anglais), est de nature à modifier le signe de l'écart entre les tensions d'entrée. La tension en sortie de l'étage différentiel s'exprime alors comme étant l'écart réel entre les tensions d'entrée auquel s'ajoute la tension de décalage.

Par conséquent, l'amplificateur peut générer en sortie un niveau de tension qui ne correspond pas au niveau de tension associé à l'écart réel entre les tensions d'entrée.

Afin de compenser ce décalage, on peut procéder à la calibration de l'amplificateur opérationnel. Lors de la calibration, il convient typiquement d'isoler l'amplificateur opérationnel du reste du circuit intégré et de court-circuiter les entrées de l'amplificateur opérationnel. De cette manière, l'amplificateur fonctionne en comparateur et on peut maintenir un écart réel nul entre les tensions appliquées en entrée de l'amplificateur, de sorte que seule la tension de décalage a un effet sur la sortie de l'amplificateur.

La tension produite par l'étage différentiel ne s'exprime alors qu'en fonction du décalage en tension entre les entrées du premier amplificateur (c'est-à-dire la tension de décalage) et le premier amplificateur génère un premier ou deuxième niveau de tension selon le signe de la tension de décalage.

Une phase de calibration classique comprend une comparaison du signal de sortie du premier amplificateur à un seuil et une compensation de la tension de décalage du premier amplificateur. La compensation de la tension de décalage faite par des techniques classiques comprend par exemple l'ajout d'un courant de compensation dans l'une des branches différentielles du premier amplificateur, de signe correspondant au décalage.

La compensation du décalage en tension peut être détectée lors de la transition entre l'un des niveaux de tension vers l'autre niveau de tension, c'est-à-dire lors du changement de signe du décalage, soit lorsque la tension de décalage est nulle. Cette transition est détectée grâce au seuil qui est défini à un niveau de tension situé entre les deux niveaux de tension pouvant être générés par le premier amplificateur.

Néanmoins, le temps de transition entre les niveaux de tension générés par le premier amplificateur est long, en raison du courant de sortie du premier amplificateur très faible pour produire une tension par charge capacitive sur le nœud de sortie. La valeur capacitive sur le nœud de sortie peut provenir par exemple de capacités parasites situées dans l'étage de sortie du premier amplificateur et/ou de capacités de compensation en fréquence typiquement placées en sortie du premier amplificateur, afin d'assurer la stabilité du signal de sortie de l'amplificateur en boucle fermée.

Par conséquent, le délai de détection de la transition est long et la phase de calibration prend un temps non négligeable, qui retarde la phase de démarrage du circuit intégré.

Ainsi, il existe un besoin de proposer des solutions à ce problème. US 2010/213983 A1 propose un système d'amplificateur avec une calibration automatique de l'offset à la mise sous tension (power-on trim). Le système comprend un amplificateur, un comparateur, un registre à approximation successive (SAR), et un convertisseur numérique-analogique (DAC). L'innovation principale réside dans l'utilisation d'un DAC non-binaire, avec un ratio de pondération des bits (radix) inférieur à 2 (par exemple 1,9) pour les bits les plus significatifs, ce qui relâche les contraintes de correspondance (matching) des composants du DAC. Ceci permet une calibration précise de l'offset sans nécessiter de mémoire non-volatile, ni de tests de production complexes. L'invention couvre aussi des variantes avec mémoire OTP (One-Time-Programmable) pour conserver la valeur de calibration, et des architectures d'amplificateur spécifiques pour faciliter la calibration.

US 11 239 807 B1 décrit un amplificateur différentiel avec compensation d'offset utilisant un circuit de calibration basé sur une architecture dite « multi-tanh ». Ce circuit de compensation comprend plusieurs paires différentielles connectées en parallèle, chacune recevant des tensions de référence différentes, et alimentées par des sources de courant constantes. L'innovation principale est que la somme des réponses en courant des différentes paires différentielles offre une plage linéaire plus large et une granularité de compensation plus fine que les solutions classiques à une seule paire différentielle. La calibration de l'offset est réalisée via un SAR ADC et un DAC, qui génèrent la tension de contrôle de compensation. L'invention permet ainsi une compensation d'offset plus précise et linéaire, adaptée aux applications nécessitant une grande exactitude.

Des modes de mise en œuvre et de réalisation proposent un circuit de calibration permettant d'accélérer le processus de calibration d'un premier amplificateur au sein d'un circuit intégré.

Selon un aspect, il est proposé un procédé de compensation d'un décalage interne en tension entre une entrée positive et une entrée négative d'un premier amplificateur.

Le procédé comprend un couplage de l'entrée négative et de l'entrée positive du premier amplificateur à un même niveau de tension, de manière à générer un courant de comparaison sur une sortie du premier amplificateur. Le signe du courant de comparaison est représentatif du signe du décalage interne en tension sur les entrées du premier amplificateur.

Le procédé comprend une polarisation de la sortie du premier amplificateur à une tension de seuil, avec un convertisseur courant-tension, et la génération d'une tension de commande avec le convertisseur courant-tension comprenant la somme de la tension de seuil et d'une conversion en tension du courant de comparaison.

Et le procédé comprend une compensation du décalage interne en tension entre les entrées du premier amplificateur, en fonction de la tension de commande.

La polarisation de la sortie du premier amplificateur à la tension de seuil permet de « pré-charger » les capacités parasites en sortie du premier amplificateur à la tension de référence, de sorte que ce n'est pas le courant de comparaison, de faible intensité, qui charge lentement les capacités parasites. En d'autres termes, on s'affranchit de la durée nécessaire au chargement des capacités parasites par le courant de comparaison, ce qui permet de réduire la durée de la phase de calibration.

Ainsi, un changement de signe du courant de sortie, résultant d'un changement de signe de la tension de décalage entre les entrées du premier amplificateur, est converti en la composante en tension respective dans la tension de commande. En conséquence, le niveau de la tension de commande en sortie du convertisseur courant-tension bascule très rapidement, sans temps de charge desdites capacités parasites, afin de commander la compensation du décalage.

Par conséquent, la transition de la tension de commande est beaucoup plus rapide qu'une transition classique de grande amplitude entre les niveaux de tension « 0 » ou « 1 » générés en sortie du premier amplificateur et la tension de seuil, par chargement capacitif avec le courant de sortie de faible intensité.

Selon un mode de mise en œuvre, le procédé comprend en outre une commande d'un élément déclencheur avec la tension de commande, l'élément déclencheur générant un signal déclencheur pouvant avoir deux niveaux et basculant à ladite tension de seuil, la compensation du décalage interne entre les entrées du premier amplificateur étant effectuée jusqu'au basculement du signal déclencheur.

L'élément déclencheur permet de détecter automatiquement une transition de la tension de commande à un instant précis à partir duquel le décalage en tension est compensé.

Selon un mode de mise en œuvre, la compensation du décalage interne entre les entrées du premier amplificateur comprend une génération d'un signal de compensation graduellement et par paliers successivement cadencés par des cycles d'un signal de cadencement, le signal de compensation étant transmis au premier amplificateur et adapté pour compenser le décalage interne en tension entre les entrées du premier amplificateur.

Un cadencement du signal de compensation permet de modifier progressivement le décalage interne en tension entre les entrées du premier amplificateur et d'éviter que le signal de compensation ait une valeur trop faible ou trop élevée pour compenser correctement le décalage en tension.

Selon un mode de mise en œuvre, ladite génération du signal de compensation évolue graduellement par une augmentation à chaque palier si la différence entre la tension de commande et la tension de seuil est d'un premier signe, ou par une diminution à chaque palier si la différence entre la tension de commande et la tension de seuil est d'un deuxième signe opposé au premier signe.

Le procédé de calibration peut donc s'adapter au signe du décalage en tension et ajuster progressivement le signal de compensation afin de limiter le décalage.

Selon un mode de mise en œuvre, la durée des cycles du signal de cadencement est fixée selon le temps de conversion en tension dudit courant de comparaison lors d'un changement de signe du courant de comparaison.

En effet, chaque cycle du signal de cadencement a avantageusement une durée correspondant au moins au temps nécessaire à la transition dans le signal de commande causée par une compensation du décalage. Or, étant donné que dans le procédé selon l'aspect défini ci-avant, la transition est plus rapide que dans les techniques classiques, la durée de chaque cycle de cadencement est avantageusement réduite en conséquence. En outre, la durée totale d'une phase de calibration correspondant au cumul des durées de cadencement jusqu'à la compensation du décalage se trouve réduite en proportion d'un facteur égal au nombre de cycles pour sa mise en œuvre.

Selon un mode de mise en œuvre, la polarisation de la sortie du premier amplificateur avec le convertisseur courant-tension comprend une application d'une tension de référence sur une entrée non-inverseuse d'un deuxième amplificateur opérationnel et une rétroaction résistive entre la sortie et une entrée inverseuse du deuxième amplificateur opérationnel de sorte à polariser la sortie du premier amplificateur à la tension de seuil.

Ce mode de mise en œuvre correspond à un exemple avantageux en matière de temps de réponse de la conversion courant-tension, de stabilité de la polarisation de la sortie du premier amplificateur, et en outre en matière de coût et d'encombrement.

Selon un autre aspect, il est également proposé un circuit intégré comprenant un premier amplificateur et un circuit de compensation d'un décalage interne en tension entre une entrée positive et une entrée négative du premier amplificateur.

Le circuit de compensation comprend un circuit de commutation configuré pour coupler l'entrée négative et l'entrée positive du premier amplificateur à un même niveau de tension, de sorte que le premier amplificateur est configuré pour générer un courant de comparaison sur une sortie du premier amplificateur, le signe du courant de comparaison étant représentatif du signe du décalage interne en tension sur les entrées du premier amplificateur.

Le circuit de compensation comprend un circuit convertisseur courant-tension, configuré pour polariser la sortie du premier amplificateur à une tension de seuil et générer une tension de commande comprenant la somme de la tension de seuil et une conversion en tension du courant de comparaison.

Le circuit de compensation est configuré pour générer un signal de compensation du décalage interne en tension entre les entrées du premier amplificateur, en fonction de la différence entre la tension de commande et la tension de seuil.

Selon un mode de réalisation, le circuit de compensation comprend un élément déclencheur apte à générer un signal déclencheur pouvant avoir deux niveaux et configuré pour être commandé par la tension de commande et pour basculer à ladite tension de seuil, le circuit de compensation étant configuré pour générer ledit signal de compensation jusqu'au basculement du signal déclencheur.

Selon un mode de réalisation, le circuit de compensation est en outre configuré pour recevoir un signal de cadencement et générer un signal de compensation graduellement et par paliers successivement cadencés par des cycles du signal de cadencement, et pour transmettre au premier amplificateur le signal de compensation adapté pour compenser le décalage interne en tension entre les entrées du premier amplificateur.

Selon un mode de réalisation, le circuit de compensation est configuré pour générer ledit signal de compensation évoluant graduellement par une augmentation à chaque palier si la différence entre la tension de commande et la tension de seuil est d'un premier signe, ou par une diminution à chaque palier si la différence entre la tension de commande et la tension de seuil est d'un deuxième signe opposé au premier signe.

Selon un mode de réalisation, le circuit de compensation est configuré pour être cadencé par des cycles du signal de cadencement ayant une durée fixée selon le temps de conversion en tension dudit courant de comparaison lors d'un changement de signe du courant de comparaison.

Selon un mode de réalisation, le convertisseur courant-tension comprend un deuxième amplificateur opérationnel et comprend en outre une résistance de rétroaction entre la sortie et une entrée inverseuse du deuxième amplificateur opérationnel, et une source de tension appliquant une tension de référence sur l'entrée non-inverseuse du deuxième amplificateur opérationnel de sorte à polariser la sortie du premier amplificateur à la tension de seuil.

D'autres avantages et caractéristiques de l'invention apparaîtront à l'examen de la description détaillée de modes de réalisation et de mise en œuvre, nullement limitatifs, et des dessins annexés, sur lesquels :
[Fig 1]
[Fig 2]
[Fig 3]

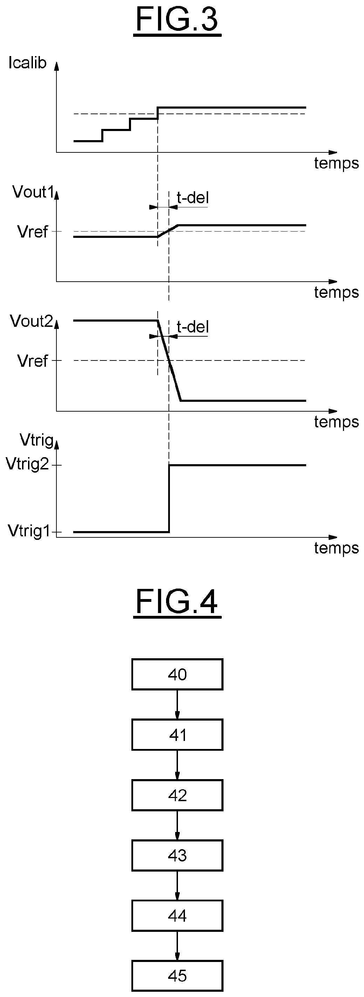

[Fig 4] illustrent schématiquement des modes de réalisation et de mise en œuvre de l'invention.

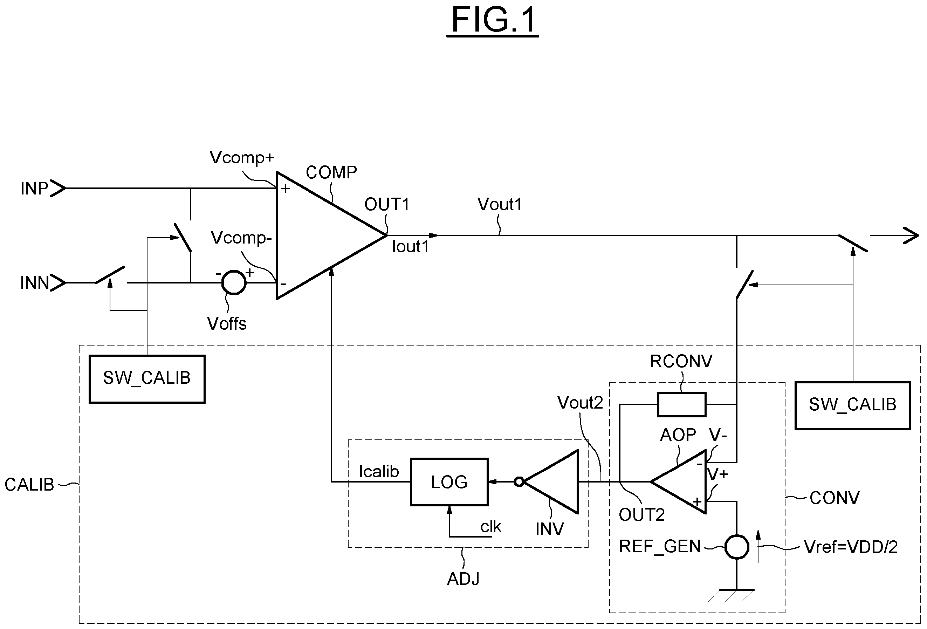

La figure 1 illustre un circuit intégré selon un mode de réalisation de l'invention. Le circuit intégré comprend un premier amplificateur COMP et un circuit de calibration CALIB.

Le premier amplificateur COMP est un amplificateur opérationnel qui comprend une entrée positive Vcomp+, une entrée négative Vcomp- et une sortie OUT1.

Un tel amplificateur opérationnel présente typiquement un décalage en tension interne Voffs entre les entrées Vcomp+ et Vcomp-, de façon classique et connue de l'homme du metier. Le décalage interne en tension Voffs est modélisé ici comme une source de tension placée sur l'entrée négative Vcomp- du premier amplificateur COMP et n'est pas présent en pratique.

L'entrée positive Vcomp+, l'entrée négative Vcomp- et la sortie OUT1 du premier amplificateur COMP peuvent être connectées à un circuit appartenant au reste du circuit intégré, non-représenté sur la figure 1, lorsque le premier amplificateur COMP n'est pas en phase de calibration.

Le circuit de calibration CALIB comprend un circuit de commutation SW_CALIB, un circuit convertisseur courant-tension CONV et un circuit de compensation ADJ.

Le circuit de commutation SW_CALIB est configuré pour coupler l'entrée négative Vcomp- avec l'entrée positive Vcomp+ dans la phase de calibration. L'entrée négative Vcomp- et l'entrée positive Vcomp+ du premier amplificateur COMP sont ainsi à un même niveau de tension, et en conséquence l'amplificateur COMP a un fonctionnement de comparateur pendant la phase de calibration.

On peut prévoir, par exemple, un interrupteur placé entre l'entrée négative Vcomp- et l'entrée positive Vcomp+ permettant de court-circuiter les entrées du premier amplificateur COMP lorsque l'interrupteur est activé par le circuit de commutation SW_CALIB afin d'obtenir un même niveau de tension entre les entrées du premier amplificateur COMP. Un interrupteur peut également être placé sur une entrée du premier amplificateur COMP et être commandé par le circuit de commutation SW_CALIB afin d'isoler les entrées du premier amplificateur COMP du reste du circuit intégré lors de la phase de calibration.

Etant donné que les entrées Vcomp- et Vcomp+ du premier amplificateur COMP sont couplées à un même niveau de tension, le premier amplificateur COMP réagit seulement à une tension d'entrée correspondant au décalage en tension Voffs entre les entrées Vcomp- et Vcomp+. En conséquence, le premier amplificateur COMP tend à imposer sur la sortie OUT1 une tension de comparaison, usuellement désignée « 0 » ou « 1 », correspondant au signe de la différence perçue entre les entrées. Un courant de comparaison Iout1 s'écoule donc sur la sortie OUT1 en raison des éléments capacitifs parasites présents sur le nœud de sortie OUT1. L'intensité du courant de comparaison Iout1 est relativement faible pour charger la capacité parasite du nœud de sortie OUT1, et la variation de la tension Vout1 sur le nœud de sortie OUT1 est relativement lente. Le signe du courant de comparaison Iout1 est donc représentatif du signe du décalage interne en tension Voffs sur les entrées Vcomp- et Vcomp+ du premier amplificateur COMP.

Le convertisseur courant-tension CONV comprend un deuxième amplificateur opérationnel AOP et une résistance de rétroaction RCONV. La résistance de rétroaction RCONV est placée entre la sortie OUT2 et une entrée inverseuse V- du deuxième amplificateur opérationnel AOP. L'entrée inverseuse V- du deuxième amplificateur opérationnel AOP est connectée à la sortie OUT1 du premier amplificateur COMP.

Le convertisseur courant-tension comprend également une source de tension REF_GEN connectée à l'entrée non-inverseuse V+ du deuxième amplificateur opérationnel AOP. La source de tension REF_GEN applique une tension de référence Vref sur l'entrée non-inverseuse V+ du deuxième amplificateur opérationnel AOP. Du fait de la rétroaction résistive RCONV de la sortie OUT2 sur l'entrée inverseuse V-, la tension de l'entrée non-inverseuse V+ est imposée sur l'entrée inverseuse V- du deuxième amplificateur opérationnel AOP.

Ainsi, la tension de référence Vref est imposée sur le nœud de sortie OUT1 du premier amplificateur COMP par le convertisseur courant-tension CONV, c'est à dire Vout1=Vref.

D'autre part, le convertisseur courant-tension CONV génère une tension de commande Vout2 sur la sortie OUT2 du deuxième amplificateur opérationnel AOP, qui est égale à la somme de la tension de référence Vref appliquée sur l'entrée non-inverseuse V+ et de la tension de conversion aux bornes de la résistance de rétroaction RCONV. La tension de conversion aux bornes de la résistance de rétroaction RCONV est générée par l'écoulement du courant de comparaison Iout1 provenant de la sortie OUT1 du premier amplificateur COMP.

En toute rigueur, et de façon connue de l'homme de l'art et classique dans les convertisseurs courant-tension, il faut ajouter à la tension de sortie Vout1 une composante égale à la tension de conversion (aux bornes de la résistance de rétroaction RCONV) divisée par le gain du deuxième amplificateur opérationnel AOP. Pour un gain idéal infini, cette composante est nulle. En pratique, cette composante est très petite (comme représenté sur la figure 3 décrite ci-après) et est considérée négligeable.

En d'autres termes, le convertisseur courant-tension CONV est configuré d'une part pour imposer la tension de référence Vref sur la sortie OUT1 de l'amplificateur COMP, et d'autre part pour générer une tension de commande Vout2 comprenant la somme d'une conversion en tension du courant de comparaison Iout1*RCONV et de la tension de référence Vref.

Le signe du courant Iout1 est dûment pris en compte dans ladite somme, de sorte qu'un courant positif s'écoulant depuis le nœud de sortie OUT1 de l'amplificateur COMP vers l'élément résistif RCONV produit une tension de conversion Iout1*RCONV d'influence négative sur la tension de sortie Vout2 du deuxième amplificateur opérationnel AOP.

Le convertisseur courant-tension CONV peut avantageusement être configuré pour avoir une sortie présentant de très faibles capacités parasites, et être optimisé pour avoir une vitesse de conversion courant-tension rapide. D'autre part, la tension de conversion Iout1*RCONV entre les bornes de la résistance RCONV est configuré pour être suffisamment petite pour ne pas engendrer de variations sur l'entrée V-en dehors de la plage de fonctionnement du deuxième amplificateur AOP.

La tension de référence Vref est avantageusement choisie pour être égale à la tension de seuil d'un élément déclencheur INV qui sera décrit ultérieurement. Le circuit de compensation ADJ est configuré pour générer un signal de compensation Icalib adapté pour compenser le décalage interne en tension Voffs entre les entrées du premier amplificateur Vcomp+ et Vcomp-. Le signal de compensation Icalib est généré en fonction de la différence entre la tension de commande Vout2 et la tension de seuil Vref, en particulier en ce qui concerne l'orientation positive ou négative de la compensation.

Le circuit de compensation ADJ comprend un élément déclencheur INV et un circuit logique LOG. L'élément déclencheur INV est connecté à la sortie OUT2 du deuxième amplificateur opérationnel AOP et est configuré pour générer un signal déclencheur Vtrig lorsque la tension sur la sortie OUT2 dépasse la tension de seuil Vref mentionnée ci-avant. Le circuit logique LOG est connecté à la sortie de l'élément déclencher INV et au premier amplificateur COMP.

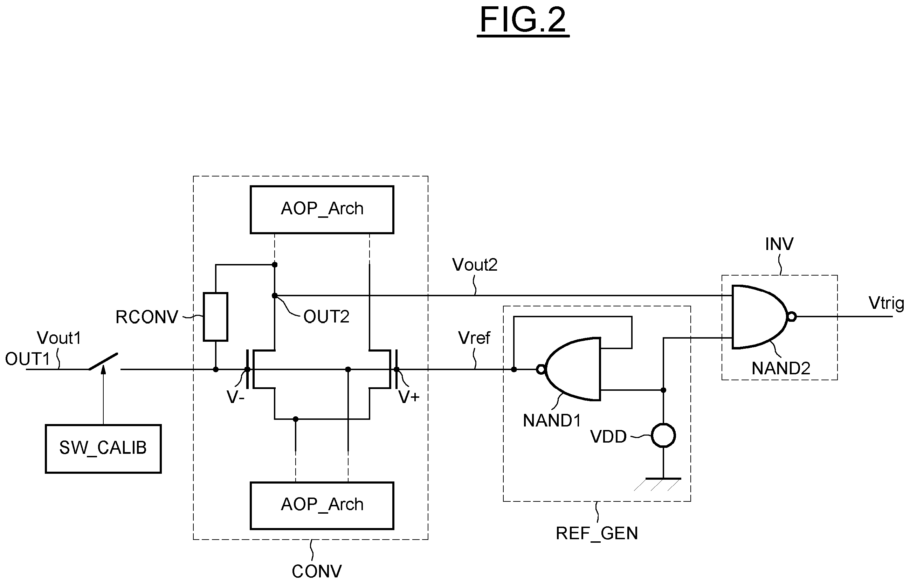

La figure 2 illustre schématiquement un exemple de convertisseur courant-tension et d'élément déclencheur INV pouvant être utilisés dans le circuit de calibration CALIB.

La source de tension REF_GEN et l'élément déclencheur INV peuvent comporter chacun une porte logique « NON-ET ». La première porte logique NAND1 de la source de tension REF_GEN possède une entrée et une sortie reliée ensemble et une autre entrée sur laquelle est appliquée une tension correspondant à un niveau logique '1' générée par un générateur de tension VDD. La deuxième porte logique NAND2 de l'élément déclencheur INV possède une entrée connectée à la sortie OUT2 du deuxième amplificateur opérationnel AOP et une autre entrée sur laquelle est appliquée une tension correspondant à un niveau logique '1' générée par le générateur de tension VDD.

Ainsi, d'une part, la première porte logique NAND1 est connectée dans un état logique indéterminé qui atteint un équilibre en générant la tension de référence Vref précisément à la valeur de sa tension de seuil.

En alternative, la première porte logique générant la tension de référence Vref peut être obtenue par un inverseur dont la sortie est rebouclée sur l'entrée. Cela étant, une porte « NON-ET » NAND1 peut avantageusement être commandée sur l'autre entrée (non-rebouclée depuis la sortie) avec un signal de désactivation au niveau logique « 0 » (par exemple via un circuit commutateur non représenté sur la figure 2), afin de ne pas consommer de courant du tout lorsque le circuit de calibration est éteint.

D'autre part, la deuxième porte logique NAND2 est connectée en inverseur et est apte à générer un signal de déclenchement Vtrig. La valeur logique générée en sortie de la deuxième porte logique NAND2 correspond à un niveau logique inverse de la valeur transmise par la sortie OUT2 du deuxième amplificateur opérationnel AOP.

Par ailleurs, la première porte logique NAND1 et la deuxième porte logique NAND2 sont avantageusement appairées (usuellement « matched » en anglais), c'est-à-dire fabriquées par les mêmes étapes de procédé, avec les mêmes caractéristiques et dimensions, et dans la même localité du circuit intégré. En conséquence, la première porte logique NAND1 et la deuxième porte logique NAND2 ont précisément la même tension de seuil en tenant comptes des aléas physiques de procédé de fabrication.

Le signal de déclenchement Vtrig a un niveau logique déterminé par la différence entre la tension de commande Vout2 et la tension de seuil Vref des portes logiques NAND1, NAND2.

Une tension de commande Vout2 supérieure à la tension de seuil Vref, correspondant par exemple au niveau logique '1', engendre un signal de déclenchement Vtrig d'un premier niveau logique Vtrig1, par exemple le niveau logique '0'. Une tension de commande Vout2 inférieure à la tension de seuil Vref, correspondant par exemple au niveau logique '0', engendre un signal de déclenchement Vtrig d'un deuxième niveau logique Vtrig2, par exemple le niveau logique '1'.

La figure 3 illustre graphiquement l'évolution du signal de compensation Icalib, de la tension de sortie Vout1 du premier amplificateur COMP, de la tension de commande Vout2 en sortie du deuxième amplificateur AOP, et du signal déclencheur Vtrig au cours du temps pour un décalage interne en tension négatif entre les entrées du premier amplificateur.

Le circuit de compensation ADJ est configuré pour générer et transmettre au premier amplificateur COMP le signal de compensation Icalib. Le signal de compensation Icalib peut être un courant généré et transmis au premier amplificateur COMP par le circuit logique LOG, et adapté pour compenser le décalage interne en tension entre les entrées Vcomp- et Vcomp+ du premier amplificateur COMP. Le courant de compensation Icalib peut servir par exemple à biaiser un courant s'écoulant dans les branches différentielles d'entrée du premier amplificateur COMP pour compenser le décalage en tension Voffs de façon classique et connue de l'homme de l'art.

La tension de sortie Vout1 de l'amplificateur COMP est imposée au niveau de la tension de référence Vref, néanmoins décalé de la composante mentionnée ci-avant égale à la tension de conversion divisée par le gain du deuxième amplificateur opérationnel AOP. Cette composante est négligeable et varie très peu de sorte que les capacités parasites sur le nœud de sortie OUT1 se chargent très vite et la durée t-Del d'une transition de la sorite OUT1 par l'effet du signal de compensation Icalib est très courte.

La tension de commande Vout2 en sortie du deuxième amplificateur opérationnel AOP est centrée sur le niveau de la tension de référence Vref et décalée de la tension de conversion Iout1*RCONV, en tenant compte du signe du courant Iout1, on peut exprimer Vout2=Vref+(-Iout1)*RCONV. En effet, le courant Iout1 sortant de l'amplificateur COMP est de signe négatif dans l'exemple illustré par la figure 3 (décalage interne en tension Voffs négatif).

L'élément déclencheur INV est configuré pour être commandé par la tension de commande Vout2 et pour basculer à la tension de seuil Vref. En particulier, le basculement de l'élément déclencheur INV s'effectue lorsque la tension de commande Vout2 atteint la tension de seuil Vref et le signal de déclenchement Vtrig passe du premier niveau logique Vtrig1 au deuxième niveau logique Vtrig2.

Le circuit de compensation ADJ est en outre configuré pour arrêter de générer le signal de compensation Icalib au moment du basculement du signal déclencheur Vtrig, c'est-à-dire lorsque le courant de comparaison Iout1 a changé de signe, et donc lorsque le décalage Voffs est compensé.

Avantageusement, le circuit de compensation ADJ est configuré pour générer progressivement le signal de compensation Icalib de façon cadencée par un signal de cadencement Clk. Le circuit logique LOG peut, par exemple, générer le signal de compensation Icalib graduellement et par palier successivement cadencés par des cycles du signal de cadencement Clk. Cela permet d'approcher progressivement la valeur permettant de compenser le décalage Voffs. La graduation de chaque palier peut être constante, par exemple dans une approche simple pas-à-pas, ou peut diminuer à chaque palier, par exemple dans une approche par dichotomie.

Les cycles du signal de cadencement Clk ont avantageusement une durée fixée selon le temps t-Del de conversion en tension du courant de comparaison Iout1*RCONV lors d'un changement de signe du courant de comparaison Iout1, c'est-à-dire lors d'un basculement de la tension de commande Vout2.

En conséquence de la rapidité de la détection du changement de signe du courant de comparaison Iout1 obtenu par le un circuit de calibration CALIB, mentionnée précédemment en relation avec les figures 1 et 2, la durée de chaque cycle de cadencement ainsi que la durée totale de la phase de calibration sont réduites.

La figure 4 illustre un exemple de procédé de compensation de décalage entre les entrées d'un premier amplificateur tel que décrit précédemment en relation avec la figure 1 à 3.

Le procédé de compensation du décalage est en particulier mis en œuvre lors d'une phase de calibration du premier amplificateur COMP. La phase de calibration intervient avant la phase de démarrage du circuit intégré et permet de compenser en particulier le décalage interne en tension entre ses entrées.

A l'étape 40 du procédé, le circuit de commutation SW_CALIB commande des interrupteurs placés en entrée et sortie de l'amplificateur opérationnel afin de l'isoler du reste du circuit intégré. L'amplificateur opérationnel fonctionne alors en comparateur pendant toute la phase de calibration.

Le procédé comprend une étape 41 de couplage de l'entrée négative Vcomp- et de l'entrée positive Vcomp+ du premier amplificateur COMP à un même niveau de tension. Afin de coupler les entrées respectives du premier amplificateur COMP, le circuit de commutation SW_CALIB commande un interrupteur placé entre les deux entrées Vcomp- et Vcomp+ et court-circuite ces entrées. De cette manière, un courant de comparaison Iout1 est généré sur une sortie du premier amplificateur OUT1. Le signe du courant de comparaison est représentatif du signe du décalage interne en tension Voffs sur les entrées du premier amplificateur Vcomp+ et Vcomp-.

Le procédé comprend une étape 42 de polarisation de la sortie OUT1 du premier amplificateur à une tension de seuil Vref avec un convertisseur courant-tension CONV.

Dans cette étape 42, une tension de référence Vref est appliquée sur une entrée non-inverseuse V+ du deuxième amplificateur opérationnel AOP. Le courant de comparaison Iout1 est transmis à une entrée inverseuse V- de l'amplificateur opérationnel et est converti en tension par une rétroaction résistive RCONV réalisée entre la sortie OUT2 et l'entrée inverseuse V- du deuxième amplificateur opérationnel AOP. Le procédé comprend une étape 43 de commande d'un élément déclencheur INV avec la tension de commande Vout2. Un signal déclencheur est généré par l'élément déclencheur INV qui bascule à la tension de seuil Vref. Un signal de déclenchement de niveau Vtrig1 est généré lorsque la tension de commande Vout2 est inférieure à la tension seuil Vref et un signal de déclenchement de niveau Vtrig2 est généré dans le cas contraire.

Le procédé comprend une étape 44 de compensation du décalage interne en tension Voffs entre les entrées Vcomp- et Vcomp+ du premier amplificateur COMP en fonction de la tension de commande Vout2 et la tension de seuil Vref.

Un signal de compensation Icalib est généré graduellement et par palier et transmis au premier amplificateur COMP. Le signal de compensation Icalib est successivement cadencé par des cycles d'un signal de cadencement Clk et est adapté pour compenser le décalage interne en tension Voffs entre les entrées Vcomp- et Vcomp+ du premier amplificateur COMP.

Avantageusement, la durée des cycles du signal de cadencement Clk est fixée selon le temps t-Del de conversion en tension du courant de comparaison Iout1 lors d'un changement de signe du courant de comparaison Iout1.

Comme illustré par la figure 3, le signal de compensation Icalib augmente à chaque palier si la différence entre la tension de commande Vout2 et la tension de seuil Vref est négative, c'est-à-dire lors de la génération d'un signal déclencheur Vtrig de niveau Vtrig1. Cela étant, le signal de compensation Icalib diminue à chaque palier si la différence entre la tension de commande Vout2 et la tension de seuil Vref est positive, c'est-à-dire lors de la génération d'un signal déclencheur Vtrig de niveau Vtrig2.

La compensation du décalage Voffs est effectuée jusqu'au basculement du signal déclencheur Vtrig. Dès le basculement du signal déclencheur Vtrig, le signal de compensation Icalib est maintenu à sa dernière valeur, laquelle permettant de compenser le décalage Voffs.

L'étape 45 représente la fin de la phase de calibration. Le circuit de commutation SW_CALIB commande les interrupteurs placés en entrée et sortie du premier amplificateur COMP afin de le reconnecter au reste du circuit intégré, et commande l'interrupteur placé entre les entrées Vcomp- et Vcomp+ afin de découpler les entrées du premier amplificateur COMP.

Ainsi, la mise en œuvre du procédé permet d'accélérer la phase de calibration afin de débuter la phase de démarrage du circuit intégré plus rapidement.

## Revendications

1. Procédé de compensation d'un décalage interne en tension entre une entrée positive (Vcomp+) et une entrée négative (Vcomp-) d'un premier amplificateur opérationnel (COMP), comprenant :
- un couplage de l'entrée négative (Vcomp-) et de l'entrée positive (Vcomp+) du premier amplificateur (COMP) à un même niveau de tension, de manière à générer un courant de comparaison (Iout1) sur une sortie du premier amplificateur (OUT1), le signe du courant de comparaison étant représentatif du signe du décalage interne en tension (Voffs) sur les entrées du premier amplificateur (Vcomp+, Vcomp-) ; **caractérisé en ce que** le procédé comprend en outre les étapes suivantes :
- une polarisation de la sortie (OUT1) du premier amplificateur à une tension de seuil (Vref) avec un convertisseur courant-tension (CONV), et une génération d'une tension de commande (Vout2), avec le convertisseur courant-tension (CONV), comprenant la somme de la tension de seuil (Vref) et d'une conversion en tension du courant de comparaison (Iout1) ;
- une compensation du décalage interne en tension (Voffs) entre les entrées du premier amplificateur (Vcomp+, Vcomp-), en fonction de la tension de commande (Vout2).

2. Procédé selon la revendication 1, comprenant en outre une commande d'un élément déclencheur (INV) avec la tension de commande (Vout2), l'élément déclencheur (INV) générant un signal déclencheur (Vtrig) pouvant avoir deux niveaux (Vtrig1, Vtrig2) et basculant à ladite tension de seuil (Vref), la compensation du décalage interne (Voffs) entre les entrées (Vcomp+, Vcomp-) du premier amplificateur étant effectuée jusqu'au basculement du signal déclencheur (Vtrig).

3. Procédé selon l'une des revendications 1 ou 2, dans lequel la compensation du décalage interne entre les entrées (Vcomp+, Vcomp-) du premier amplificateur comprend une génération d'un signal de compensation (Icalib) graduellement et par paliers successivement cadencés par des cycles d'un signal de cadencement (Clk), le signal de compensation (Icalib) étant transmis au premier amplificateur (COMP) et adapté pour compenser le décalage interne en tension (Voffs) entre les entrées (Vcomp+, Vcomp-) du premier amplificateur.

4. Procédé selon la revendication 3, dans lequel ladite génération du signal de compensation (Icalib) évolue graduellement par une augmentation à chaque palier si la différence entre la tension de commande (Vout2) et la tension de seuil (Vref) est d'un premier signe, ou par une diminution à chaque palier si la différence entre la tension de commande (Vout2) et la tension de seuil (Vref) est d'un deuxième signe opposé au premier signe.

5. Procédé selon l'une des revendications 3 ou 4, dans lequel la durée des cycles du signal de cadencement est fixée selon le temps (t-Del) de conversion en tension dudit courant de comparaison (Iout1) lors d'un changement de signe du courant de comparaison (Iout1).

6. Procédé selon l'une des revendications précédentes, dans lequel la polarisation de la sortie (OUT1) du premier amplificateur avec le convertisseur courant-tension (CONV) comprend une application d'une tension de référence (Vref) sur une entrée non-inverseuse (V+) d'un deuxième amplificateur opérationnel (AOP) et une rétroaction résistive (RCONV) entre la sortie (OUT2) et une entrée inverseuse (V-) du deuxième amplificateur opérationnel (AOP) de sorte à polariser la sortie du premier amplificateur (OUT1) à la tension de référence (Vref).

7. Circuit intégré comprenant un premier amplificateur (COMP) et un circuit de calibration (CALIB) d'un décalage interne en tension (Voffs) entre une entrée positive (Vcomp+) et une entrée négative (Vcomp-) du premier amplificateur (COMP), le circuit de calibration comprenant :
- un circuit de commutation (SW_CALIB) configuré pour coupler l'entrée négative (Vcomp-) et l'entrée positive (Vcomp+) du premier amplificateur (COMP) à un même niveau de tension, de sorte que le premier amplificateur (COMP) est configuré pour générer un courant de comparaison (Iout1) sur une sortie (OUT1) du premier amplificateur, le signe du courant de comparaison étant représentatif du signe du décalage interne en tension (Voffs) sur les entrées (Vcomp+, Vcomp-) du premier amplificateur ;
**caractérisé en ce que** le circuit intégré comprend en outre :
- un circuit convertisseur courant-tension (CONV), configuré pour polariser la sortie du premier amplificateur (OUT1) à une tension de seuil (Vref) et pour générer une tension de commande (Vout2) comprenant la somme de la tension de seuil (Vref) et d'une conversion en tension du courant de comparaison (Iout1) ;
- un circuit de compensation (ADJ) configuré pour générer un signal de compensation (Icalib) du décalage interne en tension (Voffs) entre les entrées du premier amplificateur (Vcomp+, Vcomp-), en fonction de la tension de commande (Vout2).

8. Circuit intégré selon la revendication 7, dans lequel le circuit de compensation (ADJ) comprend un élément déclencheur (INV) apte à générer un signal déclencheur (Vtrig) pouvant avoir deux niveaux (Vtrig1, Vtrig2) et configuré pour être commandé par la tension de commande (Vout2) et pour basculer à ladite tension de seuil (Vref), le circuit de compensation étant configuré pour générer ledit signal de compensation (Icalib) jusqu'au basculement du signal déclencheur (Vtrig).

9. Circuit intégré selon l'une des revendications 7 ou 8, dans lequel le circuit de compensation (ADJ) est en outre configuré pour recevoir un signal de cadencement (Clk) et générer un signal de compensation (Icalib) graduellement et par paliers successivement cadencés par des cycles du signal de cadencement (Clk), et pour transmettre au premier amplificateur (COMP) le signal de compensation (Icalib) adapté pour compenser le décalage interne en tension (Voffs) entre les entrées (Vcomp+, Vcomp-) du premier amplificateur.

10. Circuit intégré selon la revendication 9, dans lequel le circuit de compensation (ADJ) est configuré pour générer ledit signal de compensation (Icalib) évoluant graduellement par une augmentation à chaque palier si la différence entre la tension de commande (Vout2) et la tension de seuil (Vref) est d'un premier signe, ou par une diminution à chaque palier si la différence entre la tension de commande (Vout2) et la tension de seuil (Vref) est d'un deuxième signe opposé au premier signe.

11. Circuit intégré selon l'une des revendications 9 ou 10, dans lequel le circuit de compensation (ADJ) est configuré pour être cadencé par des cycles du signal de cadencement (Clk) ayant une durée fixée selon le temps (t-Del) de conversion en tension dudit courant de comparaison (Iout1) lors d'un changement de signe du courant de comparaison (Iout1).

12. Circuit intégré selon l'une des revendications 7 à 11, dans lequel le convertisseur courant-tension (CONV) comprend un deuxième amplificateur opérationnel (AOP) et une résistance de rétroaction (RCONV) entre la sortie (OUT2) et une entrée inverseuse (V-) du deuxième amplificateur opérationnel (AOP), et une source de tension (REF_GEN) appliquant une tension de référence (Vref) sur l'entrée non-inverseuse (V+) de l'amplificateur opérationnel (AOP) de sorte à polariser la sortie du premier amplificateur (OUT1) à la tension de référence (Vref).

## Patentansprüche

1. Verfahren zum Kompensieren einer internen Spannungsverschiebung zwischen einem positiven Eingang (Vcomp+) und einem negativen Eingang (Vcomp-) eines ersten Betriebsverstärkers (COMP), umfassend:
- eine Kopplung des negativen Eingangs (Vcomp-) und des positiven Eingangs (Vcomp+) des ersten Verstärkers (COMP) auf denselben Spannungspegel, so dass ein Vergleichsstrom (Iout1) an einem Ausgang des ersten Verstärkers (OUT1) erzeugt wird, wobei das Vorzeichen des Vergleichsstroms repräsentativ für das Vorzeichen der internen Spannungsverschiebung (Voffs) an den Eingängen des ersten Verstärkers (Vcomp+, Vcomp-) ist;
**dadurch gekennzeichnet, dass** das Verfahren ferner die folgenden Schritte umfasst:
- eine Polarisierung des Ausgangs (OUT1) des ersten Verstärkers auf eine Schwellenspannung (Vref) mit einem Strom-Spannungswandler (CONV) und eine Erzeugung einer Steuerspannung (Vout2) mit dem Strom-Spannungswandler (CONV), die die Summe der Schwellenspannung (Vref) und einer Spannungsumwandlung des Vergleichsstroms (Iout1) umfasst;
- eine Kompensation der internen Spannungsverschiebung (Voffs) zwischen den Eingängen des ersten Verstärkers (Vcomp+, Vcomp-) in Abhängigkeit von der Steuerspannung (Vout2).

2. Verfahren nach Anspruch 1, ferner umfassend eine Steuerung eines Auslöseelements (INV) mit der Steuerspannung (Vout2), wobei das Auslöseelement (INV) ein Auslösesignal (Vtrig) erzeugt, das zwei Pegel (Vtrigl, Vtrig2) aufweisen kann und auf die Schwellenspannung (Vref) umschaltet, wobei die Kompensation der internen Verschiebung (Voffs) zwischen den Eingängen (Vcomp+, Vcomp-) des ersten Verstärkers bis zum Umschalten des Auslösesignals (Vtrig) erfolgt.

3. Verfahren nach einem der Ansprüche 1 oder 2, wobei die Kompensation der internen Verschiebung zwischen den Eingängen (Vcomp+, Vcomp-) des ersten Verstärkers das Erzeugen eines Kompensationssignals (Icalib) schrittweise und in aufeinanderfolgenden Stufen umfasst, die durch Zyklen eines Taktsignals (Clk) getaktet werden, wobei das Kompensationssignal (Icalib) an den ersten Verstärker (COMP) übertragen wird und ausgelegt ist, um die interne Spannungsverschiebung (Voffs) zwischen den Eingängen (Vcomp+, Vcomp-) des ersten Verstärkers zu kompensieren.

4. Verfahren nach Anspruch 3, wobei sich die Erzeugung des Kompensationssignals (Icalib) schrittweise durch eine Erhöhung in jeder Stufe verändert, wenn die Differenz zwischen der Steuerspannung (Vout2) und der Schwellenspannung (Vref) ein erstes Vorzeichen hat, oder durch eine Verringerung in jeder Stufe, wenn die Differenz zwischen der Steuerspannung (Vout2) und der Schwellenspannung (Vref) ein zweites, dem ersten Vorzeichen entgegengesetztes Vorzeichen hat.

5. Verfahren nach einem der Ansprüche 3 oder 4, wobei die Dauer der Zyklen des Taktsignals entsprechend der Zeit (t-Del) der Spannungsumwandlung des Vergleichsstroms (Iout1) bei einer Vorzeichenänderung des Vergleichsstroms (Iout1) festgelegt wird.

6. Verfahren nach einem der vorhergehenden Ansprüche, wobei die Polarisierung des Ausgangs (OUT1) des ersten Verstärkers mit dem Strom-Spannungswandler (CONV) das Anlegen einer Referenzspannung (Vref) an einen nicht invertierenden Eingang (V+) eines zweiten Betriebsverstärkers (AOP) und eine ohmsche Rückmeldung (RCONV) zwischen dem Ausgang (OUT2) und einem invertierenden Eingang (V-) des zweiten Betriebsverstärkers (AOP) umfasst, so dass der Ausgang des ersten Verstärkers (OUT1) auf die Referenzspannung (Vref) polarisiert wird.

7. Integrierte Schaltung, umfassend einen ersten Verstärker (COMP) und eine Kalibrierschaltung (CALIB) einer internen Spannungsverschiebung (Voffs) zwischen einem positiven Eingang (Vcomp+) und einem negativen Eingang (Vcomp-) des ersten Verstärkers (COMP), wobei die Kalibrierschaltung umfasst:
- einen Schaltkreis (SW_CALIB), der so konfiguriert ist, dass er den negativen Eingang (Vcomp-) und den positiven Eingang (Vcomp+) des ersten Verstärkers (COMP) auf denselben Spannungspegel koppelt, so dass der erste Verstärker (COMP) so konfiguriert ist, dass er einen Vergleichsstrom (Iout1) an einem Ausgang (OUT1) des ersten Verstärkers erzeugt, wobei das Vorzeichen des Vergleichsstroms repräsentativ für das Vorzeichen der internen Spannungsverschiebung (Voffs) an den Eingängen (Vcomp+, Vcomp-) des ersten Verstärkers ist;
**dadurch gekennzeichnet, dass** die integrierte Schaltung ferner umfasst:
- eine Strom-Spannungswandlerschaltung (CONV), die so konfiguriert ist, dass sie den Ausgang des ersten Verstärkers (OUT1) auf eine Schwellenspannung (Vref) polarisiert und eine Steuerspannung (Vout2) erzeugt, die die Summe der Schwellenspannung (Vref) und einer Spannungsumwandlung des Vergleichsstroms (Iout) umfasst;
- eine Kompensationsschaltung (ADJ), die so konfiguriert ist, dass sie ein Kompensationssignal (Icalib) der internen Spannungsverschiebung (Voffs) zwischen den Eingängen des ersten Verstärkers (Vcomp+, Vcomp-) in Abhängigkeit von der Steuerspannung (Vout2) erzeugt.

8. Integrierte Schaltung nach Anspruch 7, wobei die Kompensationsschaltung (ADJ) ein Auslöseelement (INV) umfasst, das in der Lage ist, ein Auslösesignal (Vtrig) zu erzeugen, das zwei Pegel (Vtrigl, Vtrig2) aufweisen kann und so konfiguriert ist, dass es von der Steuerspannung (Vout2) gesteuert wird und auf die Schwellenspannung (Vref) umschaltet, wobei die Kompensationsschaltung so konfiguriert ist, dass sie das Kompensationssignal (Icalib) bis zum Umschalten des Auslösesignals (Vtrig) erzeugt.

9. Integrierte Schaltung nach einem der Ansprüche 7 oder 8, wobei die Kompensationsschaltung (ADJ) ferner so konfiguriert ist, dass sie ein Taktsignal (Clk) empfängt und ein Kompensationssignal (Icalib) schrittweise und in aufeinanderfolgenden Schritten erzeugt, die durch Zyklen des Taktsignals (Clk) getaktet werden, und um dem ersten Verstärker (COMP) das Kompensationssignal (Icalib) zu übertragen, das ausgelegt ist, die interne Spannungsverschiebung (Voffs) zwischen den Eingängen (Vcomp+, Vcomp-) des ersten Verstärkers zu kompensieren.

10. Integrierte Schaltung nach Anspruch 9, wobei die Kompensationsschaltung (ADJ) so konfiguriert ist, dass sie das Kompensationssignal (Icalib) erzeugt, das sich schrittweise durch eine Erhöhung in jeder Stufe ändert, wenn die Differenz zwischen der Steuerspannung (Vout2) und der Schwellenspannung (Vref) ein erstes Vorzeichen hat, oder durch eine Verringerung in jeder Stufe, wenn die Differenz zwischen der Steuerspannung (Vout2) und der Schwellenspannung (Vref) ein zweites, dem ersten Vorzeichen entgegengesetztes Vorzeichen hat.

11. Integrierte Schaltung nach einem der Ansprüche 9 oder 10, wobei die Kompensationsschaltung (ADJ) so konfiguriert ist, dass sie durch Zyklen des Taktsignals (Clk) mit einer festgelegten Dauer entsprechend der Zeit (t-Del) der Spannungsumwandlung des Vergleichsstroms (Iout1) bei einer Vorzeichenänderung des Vergleichsstroms (Iout1) getaktet wird.

12. Integrierte Schaltung nach einem der Ansprüche 7 bis 11, wobei der Strom-Spannungswandler (CONV) einen zweiten Betriebsverstärker (AOP) und einen Rückkopplungswiderstand (RCONV) zwischen dem Ausgang (OUT2) und einem invertierenden Eingang (V-) des zweiten Betriebsverstärkers (AOP) sowie eine Spannungsquelle (REF_GEN) umfasst, die eine Referenzspannung (Vref) an den nicht invertierenden Eingang (V+) des Betriebsverstärkers (AOP) anlegt, um den Ausgang des ersten Verstärkers (OUT1) auf die Referenzspannung (Vref) zu polarisieren.

## Claims

1. Method for compensating for an internal voltage offset between a positive input (Vcomp+) and a negative input (Vcomp-) of a first operational amplifier (COMP), comprising:
- coupling the negative input (Vcomp-) and the positive input (Vcomp+) of the first amplifier (COMP) at the same voltage level, so as to generate a comparison current (Iout1) on an output of the first amplifier (OUT1), the sign of the comparison current being representative of the sign of the internal voltage offset (Voffs) on the inputs of the first amplifier (Vcomp+, Vcomp-);
**characterised in that** the method further comprises the following steps of:
- biassing the output (OUT1) of the first amplifier at a threshold voltage (Vref) with a current-to-voltage converter (CONV), and generating a control voltage (Vout2), with the current-to-voltage converter (CONV), comprising the sum of the threshold voltage (Vref) and of a voltage conversion of the comparison current (Iout1);
- compensating for the internal voltage offset (Voffs) between the inputs of the first amplifier (Vcomp+, Vcomp-), as a function of the control voltage (Vout2).

2. Method according to claim 1, further comprising controlling a trigger element (INV) with the control voltage (Vout2), the trigger element (INV) generating a trigger signal (Vtrig) that can have two levels (Vtrigl, Vtrig2) and switching to said threshold voltage (Vref), the compensation of the internal offset (Voffs) between the inputs (Vcomp+, Vcomp-) of the first amplifier being carried out until the switchover of the trigger signal (Vtrig) .

3. Method according to one of claims 1 or 2, wherein the compensation of the internal offset between the inputs (Vcomp+, Vcomp-) of the first amplifier comprises generating a compensation signal (Icalib) gradually and in increments successively clocked by cycles of a clock signal (Clk), the compensation signal (Icalib) being transmitted to the first amplifier (COMP) and adapted to compensate for the internal voltage offset (Voffs) between the inputs (Vcomp+, Vcomp-) of the first amplifier.

4. Method according to claim 3, wherein said generation of the compensation signal (Icalib) evolves gradually by an increase at each increment if the difference between the control voltage (Vout2) and the threshold voltage (Vref) is of a first sign, or by a decrease at each increment if the difference between the control voltage (Vout2) and the threshold voltage (Vref) is of a second sign opposite to the first sign.

5. Method according to one of claims 3 or 4, wherein the duration of the cycles of the clock signal is fixed according to the time (t- Del) of voltage conversion of said comparison current (Iout1) during a change of sign of the comparison current (Iout1).

6. Method according to one of the preceding claims, wherein the biassing of the output (OUT1) of the first amplifier with the current-to-voltage converter (CONV) comprises applying a reference voltage (Vref) to a non-inverting input (V+) of a second operational amplifier (AOP) and a resistive feedback (RCONV) between the output (OUT2) and an inverting input (V-) of the second operational amplifier (AOP) so as to bias the output of the first amplifier (OUT1) at the reference voltage (Vref).

7. Integrated circuit comprising a first amplifier (COMP) and a calibration circuit (CALIB) of an internal voltage offset (Voffs) between a positive input (Vcomp+) and a negative input (Vcomp-) of the first amplifier (COMP), the calibration circuit comprising:
- a switching circuit (SW_CALIB) configured to couple the negative input (Vcomp-) and the positive input (Vcomp+) of the first amplifier (COMP) at the same voltage level, so that the first amplifier (COMP) is configured to generate a comparison current (Iout1) on an output (OUT1) of the first amplifier, the sign of the comparison current being representative of the sign of the internal voltage offset (Voffs) on the inputs (Vcomp+, Vcomp-) of the first amplifier;
**characterised in that** the integrated circuit further comprises
- a current-to-voltage converter (CONV) circuit, configured to bias the output of the first amplifier (OUT1) to a threshold voltage (Vref) and to generate a control voltage (Vout2) comprising the sum of the threshold voltage (Vref) and a voltage conversion of the comparison current (Iout1);
- a compensation circuit (ADJ) configured to generate a compensation signal (Icalib) of the internal voltage offset (Voffs) between the inputs of the first amplifier (Vcomp+, Vcomp-), as a function of the control voltage (Vout2).

8. Integrated circuit according to claim 7, wherein the compensation circuit (ADJ) comprises a trigger element (INV) capable of generating a trigger signal (Vtrig) that may have two levels (Vtrig1, Vtrig2) and configured to be controlled by the control voltage (Vout2) and to switch to said threshold voltage (Vref), the compensation circuit being configured to generate said compensation signal (Icalib) until the switchover of the trigger signal (Vtrig).

9. Integrated circuit according to one of claims 7 or 8, wherein the compensation circuit (ADJ) is further configured to receive a clock signal (Clk) and generate a compensation signal (Icalib) gradually and in increments successively clocked by cycles of the clock signal (Clk), and to transmit to the first amplifier (COMP) the compensation signal (Icalib) adapted to compensate for the internal voltage offset (Voffs) between the inputs (Vcomp+, Vcomp-) of the first amplifier.

10. Integrated circuit according to claim 9, wherein the compensation circuit (ADJ) is configured to generate said compensation signal (Icalib) evolving gradually by an increase at each increment if the difference between the control voltage (Vout2) and the threshold voltage (Vref) is of a first sign, or by a decrease at each increment if the difference between the control voltage (Vout2) and the threshold voltage (Vref) is of a second sign opposite to the first sign.

11. Integrated circuit according to one of claims 9 or 10, wherein the compensation circuit (ADJ) is configured to be clocked by cycles of the clock signal (Clk) having a fixed duration according to the time (t-Del) of voltage conversion of said comparison current (Iout1) during a change of sign of the comparison current (Iout1).

12. Integrated circuit according to one of claims 7 to 11, wherein the current-to-voltage converter (CONV) comprises a second operational amplifier (AOP) and a feedback resistor (RCONV) between the output (OUT2) and an inverting input (V-) of the second operational amplifier (AOP), and a voltage source (REF_GEN) applying a reference voltage (Vref) to the non-inverting input (V+) of the operational amplifier (AOP) so as to bias the output of the first amplifier (OUT1) at the reference voltage (Vref).
